# EUROPÄISCHE PATENTSCHRIFT

(11) **EP 3 424 107 B1**
(45) Veröffentlichungstag und Bekanntmachung des Hinweises auf die Patenterteilung: **20.07.2022**
(21) Anmeldenummer: 17707516.5
(22) Anmeldetag: 23.02.2017
(51) Int. Cl.: H01R 12/57

(54) **LEITERPLATTE MIT EINEM SCHIRMANBINDUNGSELEMENT**
PRINTED CIRCUIT BOARD WITH A SHIELD CONNECTION ELEMENT
CARTE À CIRCUIT IMPRIMÉ AVEC UN ÉLÉMENT DE LIAISON DE BLINDAGE

(30) Priorität: 02.03.2016 DE 202016101128 U
(43) Veröffentlichungstag der Anmeldung: 09.01.2019
(73) Patentinhaber: Amphenol-Tuchel Electronics GmbH, 74080 Heilbronnn (DE)
(72) Erfinder: UNGERER, Christian, 74199 Untergruppenbach-Unterheinriet (DE); KERNER, Wolfgang, 74235 Erlenbach (DE); OBEL, Manuel, 86732 Oettingen (DE); OBERHAMMER, Peter, 74599 Wallhausen (DE)
(74) Vertreter: Staeger & Sperling Partnerschaftsgesellschaft mbB
(86) Internationale Anmeldenummer: PCT/EP2017/054247
(87) Internationale Veröffentlichungsnummer: WO 2017/148803

(56) Entgegenhaltungen:
- CN-U- 203 386 920
- DE-A1-102014 108 001
- DE-U1-202013 006 781

## Beschreibung

Die vorliegende Erfindung betrifft Leiterplatte mit einem Schirmanbindungselement,.

Abschirmung elektronischer Einrichtungen und Geräte dienen in der Regel dazu, elektrische oder magnetische Felder von diesen fernzuhalten bzw. umgekehrt die Umgebung von den von der Einrichtung ausgehenden Feldern zu schützen. Das bedeutet, elektromagnetische Abschirmung kann sowohl in wie aus einer elektrischen Einrichtung einem Kabel und dergleichen erforderlich sein.

Da elektromagnetische Wellen negative Einflüsse auf andere elektrische Geräte haben können, müssen sowohl magnetische als auch elektrische Abstrahlungen sicher verhindert oder ausreichend abgeschirmt und verringert werden.

Die elektromagnetische Verträglichkeit (EMV) kennzeichnet den üblicherweise erwünschten Zustand eines Gerätes oder einer Vorrichtung. Dies drückt aus, dass solche Vorrichtungen nicht durch unbeabsichtigte oder unbestimmungsgemäße elektrische oder elektromagnetische Effekte störend beeinflusst werden. Wesentlich zur Sicherstellung der elektromagnetischen Verträglichkeit elektrischer Betriebsmittel sind deren sachgerechte Aufbau und Gestaltung. Nachweis und eine Bestätigung entsprechender Störempfindlichkeiten sind durch die EMV-Richtlinien und EMV-Normen geregelt.

Insofern ist es auch regelmäßig erforderlich, dass geschirmte Leitungen eingesetzt werden, die wiederum auf den Leiterplatten solcher elektrischen Geräte möglichst kostengünstig und einfach zu verbinden sind.

Es ist insofern notwendig, sowohl die signal- oder stromführenden Leiter mit der Leiterplatte elektrisch zu verbinden als auch den Kabelschirm mit entsprechenden Schirmvorrichtungen zu kontaktieren.

Die im Stand der Technik bekannten Lösungen zur Anbindung von geschirmten Leitungen unmittelbar an einer Leiterplatte weisen diverse Nachteile auf.

So zeigt die CN 203386920 U eine Lösung, bei der das Kontaktteil mittels mehreren Nietverbindungen auf einer Leiterplatte entsprechend einem definierten Lochbild befestigt wird, wodurch Toleranzprobleme auftreten.

So gibt es beispielsweise auch Lösungen, bei denen das Kabel derart aufgedröselt werden muss, dass der Schirm direkt an einer Schirmanbindung auf der Leiterplatte zu befestigen ist, während andererseits eine elektrische Verbindung mit den signalführenden Leitern herzustellen ist.

Dabei ist es regelmäßig schon aus Platzgründen schwierig, die Anbindung zunächst der Signalleitungen oder stromführenden Leitungen und später der Schirmanbindung vorzunehmen.

Andere bereits vollständige Steckverbinderlösungen bestehend aus einem Gehäuse, einer im Gehäuse angeordneten Schirmkontaktierung sowie einem Kontaktträger mit Kontakten sind komplex aufgebaut, teuer in der Herstellung und auch aufwendig in der Adaption an unterschiedliche Applikationen und Geräte.

Es ist daher Aufgabe der vorliegenden Erfindung, vorbesagte Nachteile zu überwinden und eine besonders universell verwendbare und einfache Lösung zur Schirmkontaktierung zwischen einer Leiterplatte und einem geschirmten Kabel vorzusehen.

Diese Aufgabe wird gelöst mit einer Leiterplatte mit den Merkmalen von Anspruch 1. Grundgedanke der vorliegenden Erfindung ist es, ein Schirmanbindungselement derart bereitzustellen, welches über wenigstens einen flachen Lötabschnitt verfügt, welcher zwischen einer Kabel- und einer Schirmcrimpung angeordnet ist, so dass der stromführende Leiter über das Kontaktteil hinausgeführt werden kann, während eine 360° Schirmanbindung des Kabelschirms des anzuschließenden Kabels möglich ist.

Durch die universelle Ausgestaltung eines solchen erfindungsgemäßen Schirmanbindungselements ist es möglich, unterschiedlichste Arten von Leiterplatten und Applikationen unmittelbar mit einem Schirmanbindungselement gemäß der vorliegenden Erfindung zu kontaktieren.

Erfindungsgemäß ist daher eine Leiterplatte vorgesehen mit einem Schirmanbindungselement umfassend ein Kontaktteil mit einem zentralen flachen Lötabschnitt, mit dem das Kontaktteil unmittelbar und elektrisch kontaktierend auf der Leiterplatte aufgelötet ist und mit zwei dazu benachbarten Crimpabschnitten, wovon wenigstens einer zur Verbindung mit einem Kabelschirm eines Kabels ausgebildet ist, wobei der Lötabschnitt zwischen dem ersten Crimpabschnitt und dem zweiten Crimpabschnitt ausgebildet ist. Auf diese Weise kann eine besonders montagefreundliche Verbindung zur Leiterplatte gebildet werden und eine entsprechende Abfolge der Kabelcrimpung, Lötanbindung und Schirmanbindung erfolgen.

Es ist in einer bevorzugten Ausführungsform der Erfindung weiter vorgesehen, dass der erste Crimpabschnitt jeweils seitlich hervorstehende Crimplaschen ausbildet, die sich in eine Richtung Q quer zur Anbindungsrichtung A an den Lötabschnitt erstrecken. Die Anbindungsrichtung A der beiden Crimpabschnitte an dem Lötabschnitt stellt auch die Längserstreckungsrichtung des Schirmanbinduhgselements dar.

Es ist weiter mit Vorteil vorgesehen, wenn der zweite Crimpabschnitt jeweils seitlich hervorstehende Crimplaschen ausbildet, die sich ebenfalls in einer Richtung quer zur Anbindungsrichtung A an den Lötabschnitt erstrecken und damit sich im Wesentlichen in die gleiche seitliche Richtung erstrecken wie die ersten Crimplaschen des ersten Crimpabschnitts.

Es ist weiter mit Vorteil erfindungsgemäß vorgesehen, dass jeder Crimpabschnitt über einen Übergangsabschnitt mit dem Lötabschnitt verbunden ist.

Mit Vorteil ist die Breite des Lötabschnitts in Querrichtung Q betrachtet größer als die Breite der jeweiligen Übergangsabschnitte.

In einer weiter vorteilhaften Ausgestaltung der Erfindung ist vorgesehen, dass die Crimplaschen des ersten Crimpabschnitts als V-förmige Laschen ausgebildet sind, die sich im Wesentlichen diametral vom Crimpabschnitt weg erstrecken und weiter bevorzugt etwas diagonal zueinander versetzt sind, so dass sie beim Umfalten um das anzubringende Kabel herum, im Wesentlichen mit ihren Enden nebeneinander in Anlage mit dem Kabel gelangen.

In einer weiter vorteilhaften Ausführungsform der Erfindung ist vorgesehen, dass die Crimplaschen des zweiten Crimpabschnitts als U-förmige oder rechteckige Laschen ausgebildet sind, wobei weiter bevorzugt die Länge der Crimplaschen des zweiten Crimpabschnitts vorzugsweise geringer ist als die Länge der Crimplaschen in Querrichtung betrachtet des ersten Crimpabschnitts.

Weiter bevorzugt ist es, wenn das Kontaktteil mit einer geschirmten Leitung verbunden ist und eine der Crimplaschen den Schirm des Kabels am Gesamtumfang, vorzugsweise über einen Winkel von 360° vollständig umschließt, so dass eine 360° Kontaktierung erreicht wird.

Erfindungsgemäß wird demnach ein umarmender O-Crimp vorgesehen sowie eine ebene Fläche zum Auflöten eines Hilfskontakts, welche durch die zuvor besagten Merkmale realisiert werden.

Durch eine solche 360° Schirmanbindung der Leitung kann eine Beschädigung des Dielektrikums verhindert werden sowie die Durchdringung der Leiterplatte.

Weitere Vorteile, Ziele und Einzelheiten der Erfindung ergeben sich aus der Beschreibung von Ausführungsbeispielen sowie anhand der Zeichnungen. In den Zeichnungen zeigen:
- Fig. 1: eine Aufsicht auf ein an einem Transportband angebrachten Paar von Schirmanbindungselementen;
- Fig. 2: eine Aufsicht auf eines der erfindungsgemäßen Schirmanbindungselemente gemäß Fig. 1, bei dem die Crimplaschen in einer anderen Montagestellung dargestellt sind;
- Fig. 3: eine Seitenansicht der Ausführungsform gemäß Fig. 2;
- Fig. 4: eine Vorderansicht der Abbildung aus Fig. 2.

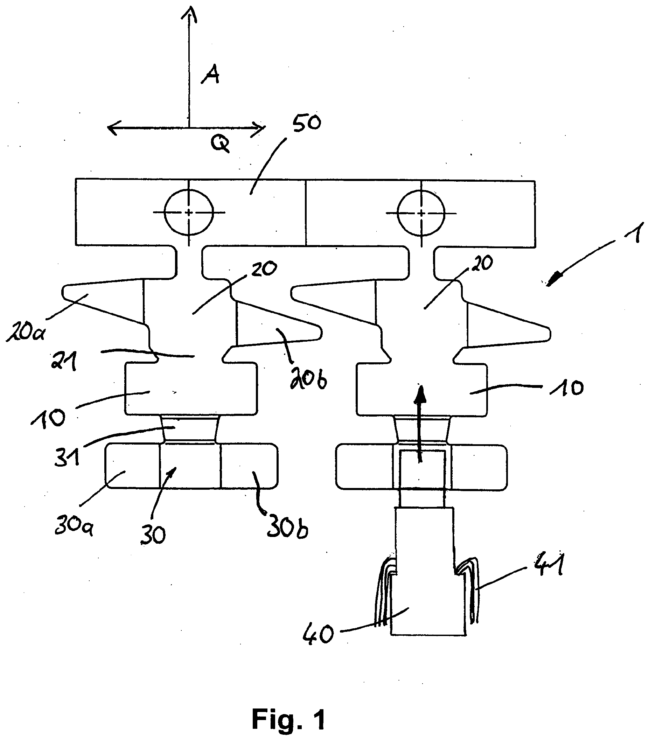

Die Erfindung wird nachfolgend mit Bezug auf die Figuren 1 bis 4 näher dargestellt, wobei gleiche Bezugszeichen auf gleiche funktionale und/oder strukturelle Merkmale hinweisen.

Dargestellt ist in den Figuren 1 bis 4 jeweils ein Schirmanbindungselement 1 für eine Leiterplatte.

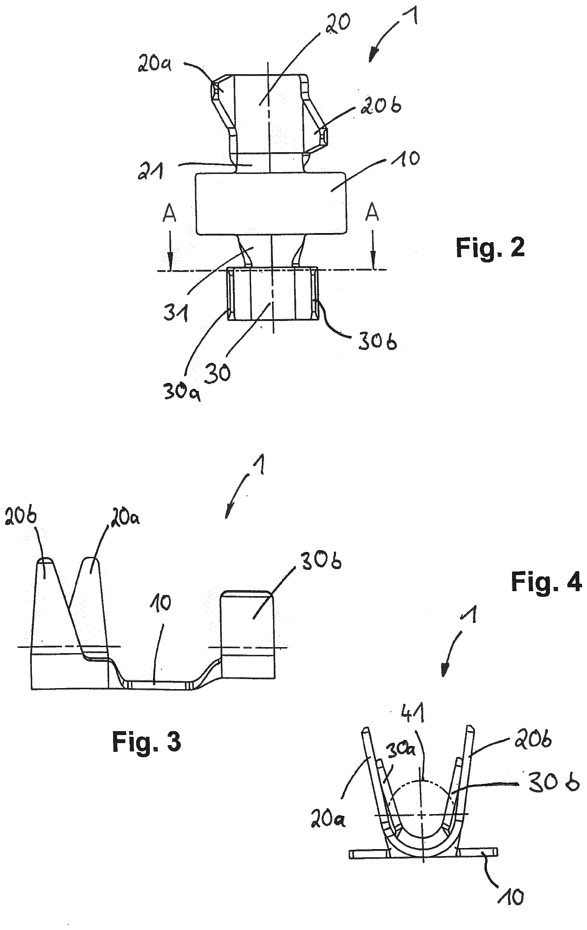

In der Fig. 1 ist ein Paar von Schirmanbindungselementen 1 an einem Transportband 50 dargestellt. Jedes Schirmanbindungselement 1 weist einen zentralen flachen Lötabschnitt 10 zum Auflöten auf einer nicht dargestellten Leiterplatte auf. Die Unterseite des Lötabschnitts 10 dient zum unmittelbaren Auflöten auf einer Leiterplatte und ist eben und flach ausgebildet, wie dies deutlich in der Fig. 3 in der Seitenansicht zu erkennen ist.

Benachbart zu dem zentralen flachen Lötabschnitt 10 befindet sich ein erster Crimpabschnitt 20 und gegenüberliegend ein zweiter Crimpabschnitt 30, wobei einer der Crimpabschnitte in dem vorliegenden Beispiel, vorzugsweise der in Fig. 1 unten liegende Crimpabschnitt 30 zur Verbindung mit dem Kabelschirm 41 eines Kabels 40 ausgebildet ist, welches beispielhaft in der Fig. 1 dargestellt ist. Dort zu sehen ist ein Kabel 40, bei dem der Kabelschirm 41 zurück gefalten ist, an den das erfindungsgemäße Schirmanbindungselement 1 (in Pfeilrichtung verschoben) anzuschließen ist.

Wie in den Figuren zu erkennen, liegt der Lötabschnitt unmittelbar zwischen den Crimpabschnitten 20, 30.

Weiter zu erkennen ist in den Figuren 1 bis 4, dass der erste Crimpabschnitt 20 jeweils seitlich hervorstehende Crimplaschen 20a, 20b ausbildet, die sich in Richtung Q quer zur Anbindungsrichtung A an den Lötabschnitten 10 erstrecken.

Ferner ist zu erkennen, dass auch der zweite Crimpabschnitt 30 jeweils seitlich hervorstehende Crimplaschen 30a, 30b ausbildet, die sich ebenfalls in Richtung Q quer zur Anbindungsrichtung A an den Lötabschnitt 10 und zwar diametral gegenüberliegend dem ersten Crimpabschnitt 20 erstrecken.

Wie ebenfalls in der Fig. 1 deutlich zu erkennen ist, ist jeder Crimpabschnitt 20, 30 über einen Übergangsabschnitt 21, 31 unmittelbar mit dem Lötabschnitt 10 einstückig verbunden. Die Breite des Lötabschnitts 10 in Querrichtung Q betrachtet, ist jeweils größer als die Breite der beiden Übergangsabschnitte 21, 31.

Wie insbesondere in der Seitenansicht der Fig. 3 ersichtlich, sind die Crimplaschen 20a, 20b des ersten Crimpabschnitts 20 als V-förmige Laschen ausgebildet und sind die Crimplaschen 30a, 30b des zweiten Crimpabschnitts 30 als U-förmige bzw. rechteckige Laschen ausgebildet.

Es ist auch ersichtlich, dass die Länge der Crimplaschen 30a, 30b des zweiten Crimpabschnitts 30 geringer ist als die Länge der Crimplaschen 20a, 20b des ersten Crimpabschnitts 20 in Querrichtung Q betrachtet bzw. insgesamt auch in der montierten Position.

Insgesamt ist vorgesehen, dass die Länge der Crimplaschen (20a, 20b, 30a, 30b) jeweils auf den Kabelquerschnitt und damit den Umfang des Kabels 40 im Schirmungsbereich abgestimmt ist.

Es ist, wie in der Fig. 4 mit einer Kreislinie angedeutet, vorgesehen, dass das Kontaktteil mit einer geschirmten Leitung so verbunden ist, dass die Crimplaschen 30a, 30b den Kabelschirm 41 des Kabels 40 am Gesamtumfang über einen Winkel von 360° umschließen und somit eine 360° Kontaktierung des Kabelschirms 41 des Kabels 40 erzielt wird.

Besonders effizient und vorteilhaft ist eine Anordnung, bei der eine Vielzahl von erfindungsgemäßen Schirmanbindungselementen 1 gemäß einer der Figuren 1 bis 3 an einem Transportband 50 befestigt werden, so dass nicht nur der Transport des Schirmungsbandes als solcher, sondern auch die Verarbeitung in einem automatisierten Prozess erfolgen kann.

Die Erfindung beschränkt sich nicht auf das vorliegend beschriebene Ausführungsbeispiel, sondern umfasst ebenso äquivalente Ausführungsformen, wenn auch nicht explizit beschrieben.

Ferner sind von der Erfindung Anordnungen umfasst, welche über die zuvor beschriebenen zentralen Elemente der erfindungsgemäßen Schirmanbindungselemente verfügen. So kann z. B. vorgesehen sein, dass ein weiterer Crimpabschnitt neben den zuvor genannten Crimpabschnitten vorgesehen ist.

### Bezugszeichenliste

- 1: Schirmanbindungselement

- 10: Lötabschnitt

- 20: erster Crimpabschnitt
- 20a, 20b: Crimplaschen
- 21: Übergangsabschnitt

- 30: zweiter Crimpabschnitt
- 30a, 30b: Crimplaschen
- 31: Übergangsabschnitt

- 40: Kabel
- 41: Kabelschirm

- 50: Transportband

- A: Anbindungsrichtung
- Q: Querrichtung

## Patentansprüche

1. Leiterplatte mit einem Schirmanbindungselement (1) umfassend ein Kontaktteil mit einem zentralen flachen Lötabschnitt (10), mit dem das Kontaktteil unmittelbar und elektrisch kontaktierend auf der Leiterplatte aufgelötet ist und mit zwei dazu benachbarten Crimpabschnitten (20, 30), wovon wenigstens einer zur Verbindung mit einem Kabelschirm (41) eines Kabels (40) ausgebildet ist, wobei der Lötabschnitt (10) zwischen dem ersten Crimpabschnitt (20) und dem zweiten Crimpabschnitt (30) ausgebildet ist.

2. Leiterplatte gemäß Anspruch 1, **dadurch gekennzeichnet, dass** der erste Crimpabschnitt (20) jeweils seitlich hervorstehende Crimplaschen (20a, 20b) ausbildet, die sich in eine Richtung (Q) quer zur Anbindungsrichtung (A) an den Lötabschnitt (10) erstrecken.

3. Leiterplatte gemäß Anspruch 1 oder 2, **dadurch gekennzeichnet, dass** der zweite Crimpabschnitt (30) jeweils seitlich hervorstehende Crimplaschen (30a, 30b) ausbildet, die sich in eine Richtung (Q) quer zur Anbindungsrichtung (A) an den Lötabschnitt (10) erstrecken.

4. Leiterplatte gemäß einem der vorhergehenden Ansprüche, **dadurch gekennzeichnet, dass** jeder Crimpabschnitt (20, 30) über einen Übergangsabschnitt (21, 31) mit dem Lötabschnitt (10) verbunden ist.

5. Leiterplatte gemäß Anspruch 4, **dadurch gekennzeichnet, dass** die Breite des Lötabschnittes (10) in Querrichtung (Q) betrachtet größer ist als die Breite der jeweiligen Übergangsabschnitte (21, 31).

6. Leiterplatte gemäß einem der Ansprüche 2 bis 5, **dadurch gekennzeichnet, dass** die Crimplaschen (20a, 20b) des ersten Crimpabschnittes (20) als V-förmige Laschen ausgebildet sind.

7. Leiterplatte gemäß einem der Ansprüche 3 bis 5, **dadurch gekennzeichnet, dass** die Crimplaschen (30a, 30b) des zweiten Crimpabschnittes (30) als U-förmige oder rechteckige Laschen ausgebildet sind, wobei die Länge der Crimplaschen (30a, 30b) des zweiten Crimpabschnittes (30) vorzugsweise geringer ist als die Länge der Crimplaschen (20a, 20b) des ersten Crimpabschnittes (20) in Querrichtung (Q) betrachtet.

8. Leiterplatte gemäß einem der Ansprüche 3 bis 7, **dadurch gekennzeichnet, dass** das Kontaktteil mit einer geschirmten Leitung verbunden ist und eine der Crimplaschen (20a, 20b) bzw. (30a, 30b) den Kabelschirm (41) des Kabels (40) am Gesamtumfang, vorzugsweise über einen Winkel von 360° umschließen, so dass eine 360° Kontaktierung erreicht wird.

## Claims

1. Printed circuit board having a shield connection element (1) comprising a contact part with a central flat soldering section (10) by way of which the contact part is soldered directly onto the printed circuit board in an electrically contact-making manner and having two crimping sections (20, 30) which are adjacent to said soldering section, at least one of which crimping sections is designed for connection to a cable shield (41) of a cable (40), wherein the soldering section (10) is formed between the first crimping section (20) and the second crimping section (30).

2. Printed circuit board according to Claim 1, **characterized in that** the first crimping section (20) forms crimping tabs (20a, 20b) which each laterally protrude and extend in a direction (Q) transverse to the direction (A) of connection to the soldering section (10).

3. Printed circuit board according to Claim 1 or 2, **characterized in that** the second crimping section (30) forms crimping tabs (30a, 30b) which each laterally protrude and extend in a direction (Q) transverse to the direction (A) of connection to the soldering section (10).

4. Printed circuit board according to one of the preceding claims, **characterized in that** each crimping section (20, 30) is connected to the soldering section (10) by means of a transition section (21, 31).

5. Printed circuit board according to Claim 4, **characterized in that** the width of the soldering section (10) as viewed in the transverse direction (Q) is greater than the width of the respective transition sections (21, 31).

6. Printed circuit board according to one of Claims 2 to 5, **characterized in that** the crimping tabs (20a, 20b) of the first crimping section (20) are designed as V-shaped tabs.

7. Printed circuit board according to one of Claims 3 to 5, **characterized in that** the crimping tabs (30a, 30b) of the second crimping section (30) are designed as U-shaped or rectangular tabs, wherein the length of the crimping tabs (30a, 30b) of the second crimping section (30) is preferably smaller than the length of the crimping tabs (20a, 20b) of the first crimping section (20) as viewed in the transverse direction (Q).

8. Printed circuit board according to one of Claims 3 to 7, **characterized in that** the contact part is connected to a shielded line, and one of the crimping tabs (20a, 20b) or (30a, 30b) encloses the cable shield (41) of the cable (40) over the entire circumference, preferably over an angle of 360°, so that 360° contact is achieved.

## Revendications

1. Carte de circuit imprimé ayant un élément de connexion de blindage (1) comprenant une partie de contact ayant une section de brasure plate centrale (10), avec laquelle la partie de contact est brasée directement et avec contact électrique sur la carte de circuit imprimé, et ayant deux sections de sertissage (20, 30) voisines de celle-ci, dont au moins une est configurée pour la liaison à un blindage de câble (41) d'un câble (40), la section de brasure (10) étant formée entre la première section de sertissage (20) et la deuxième section de sertissage (30).

2. Carte de circuit imprimé selon la revendication 1, **caractérisée en ce que** la première section de sertissage (20) forme des pattes de sertissage (20a, 20b) respectives faisant saillie latéralement, qui s'étendent dans une direction (Q) transversale à la direction de connexion (A) à la section de brasure (10).

3. Carte de circuit imprimé selon la revendication 1 ou 2, **caractérisée en ce que** la deuxième section de sertissage (30) forme des pattes de sertissage (30a, 30b) respectives faisant saillie latéralement, qui s'étendent dans une direction (Q) transversale à la direction de connexion (A) à la section de brasure (10).

4. Carte de circuit imprimé selon l'une quelconque des revendications précédentes, **caractérisée en ce que** chaque section de sertissage (20, 30) est reliée à la section de brasure (10) par l'intermédiaire d'une section de transition (21, 31).

5. Carte de circuit imprimé selon la revendication 4, **caractérisée en ce que** la largeur de la section de brasure (10), telle que vue dans la direction transversale (Q), est plus grande que la largeur des sections de transition respectives (21, 31).

6. Carte de circuit imprimé selon l'une quelconque des revendications 2 à 5, **caractérisée en ce que** les pattes de sertissage (20a, 20b) de la première section de sertissage (20) sont configurées sous forme de pattes en forme de V.

7. Carte de circuit imprimé selon l'une quelconque des revendications 3 à 5, **caractérisée en ce que** les pattes de sertissage (30a, 30b) de la deuxième section de sertissage (30) sont configurées sous forme de pattes en forme de U ou rectangulaires, la longueur des pattes de sertissage (30a, 30b) de la deuxième section de sertissage (30) étant de préférence plus petite que la longueur des pattes de sertissage (20a, 20b) de la première section de sertissage (20) telle que vue dans la direction transversale (Q).

8. Carte de circuit imprimé selon l'une quelconque des revendications 3 à 7, **caractérisée en ce que** la partie de contact est reliée à une ligne blindée et une des pattes de sertissage (20a, 20b) ou (30a, 30b) entoure le blindage de câble (41) du câble (40) sur toute la circonférence, de préférence sur un angle de 360°, de telle sorte qu'un contact sur 360° est obtenu.
